Europäisches Patentamt

European Patent Office

Office européen des brevets

(19)

(11) Publication number: **0 111 977**
**B1**

(12) **EUROPEAN PATENT SPECIFICATION**

(45) Date of publication of patent specification: **05.04.89**

(21) Application number: **83201784.2**

(22) Date of filing: **15.12.83**

(51) Int. Cl.⁴: **H 01 L 27/02,** H 01 L 21/82,
H 03 K 19/091

(54) **Integrated circuit and method.**

(30) Priority: **20.12.82 US 451138**

(43) Date of publication of application:
**27.06.84 Bulletin 84/26**

(45) Publication of the grant of the patent:
**05.04.89 Bulletin 89/14**

(84) Designated Contracting States:
**DE FR GB**

(56) References cited:
**DE-A-2 531 367**
**FR-A-2 231 112**
**FR-A-2 341 232**
**US-A-3 947 865**
**US-A-4 127 864**

**IEEE JOURNAL OF SOLID STATE CIRCUITS,
vol. SC-14, no. 3, June 1979, pages 585-590,
New York, US; J. LOHSTROH: "ISL, a fast and
dense low-power logic, made in a standard
Schottky process"**

(73) Proprietor: **N.V. Philips' Gloeilampenfabrieken
Groenewoudseweg 1
NL-5621 BA Eindhoven (NL)**

(72) Inventor: **Allison, David Frank
c/o INT. OCTROOIBUREAU B.V. Prof.Holstlaan 6
NL-5656 AA Eindhoven (NL)**

(74) Representative: **Veerman, Jan Willem et al
INTERNATIONAAL OCTROOIBUREAU B.V. Prof.
Holstlaan 6
NL-5656 AA Eindhoven (NL)**

## Description

The invention relates to an integrated circuit comprising a semiconductor body having a surface, a substrate region of a first conductivity type adjoining said surface, a first surface region of a second conductivity type being present in said substrate region and having a higher doping concentration than an adjoining part of said substrate region, said first surface region extending a first depth below said surface, a second surface region of the first conductivity type being present in said first surface region and having a higher doping concentration than an adjoining part of said first surface region, said second surface region having a second depth below said surface which is smaller than said first depth, a third surface region of the second conductivity type being present in said second surface region and having a higher doping concentration than an adjoining part of said second surface region, said third surface region having a third depth below said surface which is smaller than said second depth.

Integrated circuit structures of this kind which are often referred to as triple diffused structures, are known from U.S. Patent 4,005,470 to Tucci and Russell.

In Electronics, pages 44—42, June 8, 1978 and in IEEE Journal of Solid State Circuits, Vol. SC-14, No. 3, pages 585—590, June 1979, there is described a new type of LSI logic known as ISL, an abreviation for integrated Schottky logic. Briefly, an ISL gate comprises the combination of a current source, a normally operated, i.e. collector down, vertical npn switching transistor merged with a pnp transistor and a set of Shottky output diodes. The pnp transistor, which may have a lateral component in addition to a vertical component, clamps the npn transistor so as to prevent it from going too deeply into saturation.

Heretofore, all proposals for an ISL structure have utilized an epitaxial layer in which the components of the logic are combined. One disadvantage of the epitaxial layer form of structure is that the thickness of the epitaxial layer is a limiting factor in minimizing the base width, or thickness, of the pnp clamping transistor. The base width, in turn, limits the current gain $\beta_f$ of the pnp clamping transistor and thereby has a limiting effect on the switching speed of the npn transistor.

According to the invention an integrated circuit as described in the preamble is characterized in that said first surface region has a major portion having said first depth and a laterally-adjoining minor portion extending to a fourth depth below said surface which is smaller than said first depth and larger than said second depth, said minor portion having a lower doping concentration than said major portion, said second surface region being located partly in said major portion and partly in said minor portion of said first surface region, said third surface region being located entirely within a portion of said second surface region which extends in the major portion of the first surface region.

In this structure the transistor formed by the second surface region, the minor portion of the first surface region and the substrate region has a base which may be formed by two successive diffusions, whose depth can be more readily controlled to produce a very narrow base width. Used in an ISL-structure this transistor provides for a clamping transistor with a current gain $\beta_f$ which is improved by a factor of 3 over the epitaxial counter-part.

Preferably the integrated circuit according to the invention is further characterized in that a circumscribing surface region of the first conductivity type is present in said substrate region and having a higher doping concentration than an adjoining part of said substrate region, said circumscribing surface region surrounding and extending partly into said first surface region at said surface.

The circumscribing surface region constitutes an effective means to reduce inversion channel formation in the surface adjoining portions of the substrate region.

In a preferred form of the integrated circuit according to the invention at said surface ohmic contacts are present on said third surface region, on said second surface region and on said circumscribing surface region, respectively and at said surface one or more rectifying contacts are present which each form a Schottky diode with an adjoining part of said major portion of said first surface region.

This preferred form is particularly suitable for implementing ISL gate circuits having improved switching speed and which can be made with relatively high yield.

Furthermore the invention related to a method of fabricating a semiconductive structure, comprising:

a) providing a semiconductor body having a surface and a substrate region of a first conductivity type adjoining said surface;

b) diffusion a first region of a second conductivity type into said substrate region extending to said surface and into said substrate region a predetermined first depth below said surface;

c) diffusing a second surface region of the first conductivity type extending into said first region and a second depth below said surface that is less than said first depth;

d) diffusing a third surface region of the second conductivity type into said second surface region and extending a third depth below said surface that is less than the second depth;

e) depositing ohmic contacts on said second surface region, said third surface region, and said substrate region, characterized in that the method further comprises:

f) diffusing a further region of the second conductivity type into said substrate region contiguous with and forming an extension of said first region, said further region having a lighter doping concentration than the greater part of said first region, said further region extending to said surface and into said substrate region a fourth depth that is substantially less than said first depth, said first region and said further region forming a major portion and a minor portion, respectively, of a contiguous first surface region,

g) depositing a plurality of contacts spaced apart on the surface of said major portion of said first surface region and each forming a Schottky barrier therewith; and in that said second surface region is diffused to extend partly into said major portion and partly into said minor portion, said second depth being less than said fourth depth, said third surface region being diffused entirely within a portion of the second surface region which is located in said major portion of said first surface region.

The invention will now be described in greater detail with reference to an example and the accompanying drawings, in which

Figure 1 is a schematic circuit diagram of a basic ISL gate,

Figure 2 is a top plan view of a composite mask layout for a triple diffused ISL structure according to the invention, and

Figures 3—7 are sectional views illustrating the process steps for fabricating such triple diffused ISL structure according to the invention.

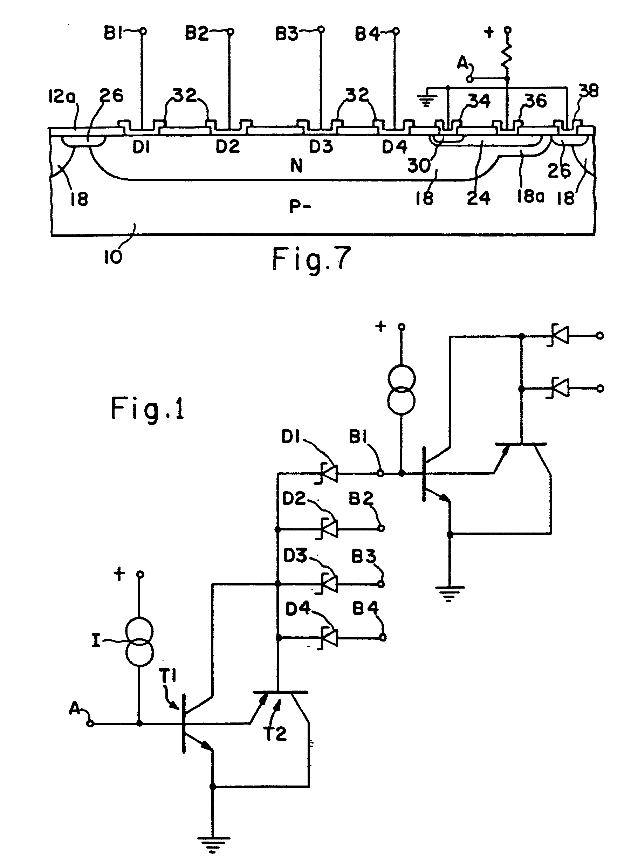

Figure 1 shows a schematic circuit diagram of a basic ISL gate. A current source I and an input signal terminal A are connected to the base of an npn inverter or switching transistor T1. Multiple outputs are obtained from the npn inverter transistor T1 by coupling the collector to the cathodes of a plurality of Schottky diodes D1, D2, D3, D4, and taking the outputs from the anodes thereof at output terminals B1, B2, B3 and B4 respectively. One or more of the outputs, such as at terminal B1, may be coupled to succeeding ISL gates, such as the one shown.

The npn inverter transistor T1 is clamped by a pnp transistor T2 to keep it from going too deeply into saturation. In practice, the pnp clamping transistor T2 may be a vertical or a lateral transistor, or a combination of the two, sharing common regions with the npn inverter transistor T1. For example, the emitter and the base of the pnp clamping transistor T2 may comprise the base and the collector, respectively, of the npn inverter transistor T1.

It has not heretofore been proposed to embody ISL logic other than in an epitaxial structure. This invention is predicated in part on the recognition that a simplified process technology and better operating performance of the ISL logic gate can be realized by embodying an ISL gate in a structure formed by a triple diffusion process.

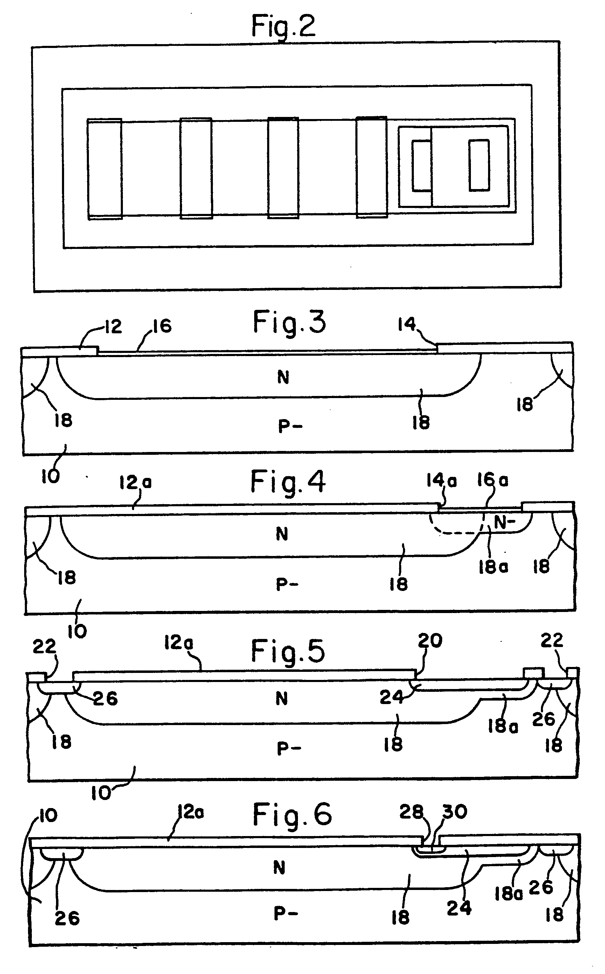

Reference is now made to Figures 2—7 for a description of a triple diffusion process for fabricating an ISL gate according to the invention. Figure 2 is a top plan view of a composite masked layout and Figures 3—7 are sectional views illustrating the sequential process steps for fabricating the triple diffused ISL structure.

As shown in Figure 3, a substrate 10 of monocrystalline semiconductor material, such as silicon, is provided with a light doping of P type impurity, such as boron. The P type doping is uniform and may have a doping concentration of $10^{15}$ atoms per cubic centimeter. The surface of the substrate 10 is provided with a first thermal oxide layer 12, which may be grown by subjecting the substrate 10 to a temperature of 1050°C for about 3 hours and 34 minutes to achieve an oxide layer 12 thickness of 6,000 angstroms.

After the first oxide layer 12 is formed, it is patterned photolithographically to produce an opening 14 through which the impurities for the collector diffusion can be introduced. Since it is preferable to implant dopant impurities through a thin oxide layer for screening purposes, a thin oxide layer 16 is formed on the surface of the substrate 10 where the collector is to be formed. The thin oxide layer 16 may be formed by etching the first oxide layer 12 down to the desired thickness. Alternatively, the first oxide layer 12 may be removed entirely from the substrate surface within the opening 14 and a new thin oxide layer 16 may be regrown by subjecting the substrate 10 to a temperature of 1000°C for 34 minutes to achieve a desired thickness of 550 angstroms.

A collector implant step is next performed by implanting an n type dopant, such as phosphorus, through the thin oxide layer 16. The total dose of phosphorus atoms is preferably $6.4 \times 10^{13}$ atoms per square centimeter. The phosphorus implant is followed by a drive-in diffusion at 1200°C for 5 hours and 40 minutes, driving the n type impurity atoms to a depth of about 7 micrometers. The collector tub or n type region thus produced is shown at 18. A number of such collector regions 18 may be formed simultaneously with each other, some of which may be provided with resistors such as for the current source I shown in Figure 1. A portion of one such additional collector region or tub 18 is shown on the right and a portion of another one is shown on the left.

After the collector tubs 18 are formed, the oxide layers 12 and 16 are stripped, and a new thick oxide layer 12a is regrown. At this time, a new opening 14a is produced for the introduction of a lighter concentration of n type impurity which is to form a short, thin n-region 18a. Prior to the impurity introduction, however, a new thin oxide layer 16a is grown, as shown in Figure 4. The n-region 18a forms a thin extension of the main collector region 18. The new opening 14a with the thin oxide layer 16a has an inner edge lying over the collector region 18 that is coincident with the right hand edge of the previous opening 14 shown in Figure 3. The width of the new opening 14a is at least about twice as long as the depth of the main collector region 18, so that the right hand edge of the new opening 14a and the left hand edge of the new opening 14a are both equidistant from the outermost surface edge of the main collector region 18.

To form the thin n-region 18a a light implant of phosphorus atoms is made through the thin oxide layer 16a. The phosphorus dose is typically $4 \times 10^{12}$ atoms per square centimeter. Following the implantation, the phosphorus atoms are driven at 1,000°C to a depth of 2 micrometers. During the drive-in diffusion a part of the driven phosphorus atoms diffuse into the already formed collector region 18, as shown by the dashed lines, while the other part of the driven atoms diffuse into the substrate 10 and form the thin extension 18a adjoining the main collector region 18, but still spaced from the adjacent collector region 18.

Figure 5 shows the next series of steps in the fabrication process. New openings 20 and 22 are formed within the oxide layer 12a. The single opening 20 is formed to expose both a part of the thin collector region 18a and an adjoining part of the main collector region 18. The two smaller openings 22 are formed to expose surface areas of the substrate between adjacent collector regions 18.

After the openings 20 and 22 are formed, a p-type diffusion is made through the openings 20 and 22 to produce a base region 24 and channel stop regions 26. The p-type diffusion is done in three steps. First, the p type dopant such as boron, is deposited on the exposed surfaces by passing a boron containing gas, such as boric acid, $HBO_2$ over the semiconductor surface while the substrate is heated at 930°C for 1 hour and 42 minutes. Finally, a drive-in diffusion is made in an oxidizing atmosphere at a substrate temperature of 1050°C for 45 minutes to drive the p type impurities in regions 24 and 26 to a depth of 1 micrometer and simultaneously grow 4,000 angstroms of oxide.

The channel stop regions 26 are p+ regions and act to prevent leakage of charge carriers between the adjacent tubs 18 by preventing an n type inversion layer from forming in these regions. The channel stop regions 26 overlap the collector region 18 and the next adjacent collector tub 18 and are also closely spaced to the thin collector region 18a. The base region 24 lies partly in the thin collector region 18a and partly in the main collector region 18.

During the oxidation step and during the base drive-in step, an oxide layer forms over the openings 20 and 22, thereby completely covering the semiconductor surface with the oxide layer 12a. While the oxide layer 12a after the base drive-in diffusion may be thinner over the base region 24 and channel stop regions 26 than in the other regions, for drawing simplicity it is shown uniformly thick in Figure 6.

Figure 6 shows the next step, in which an opening 28 is formed in the oxide layer 12a. The opening 28 lies over the part of the base region 24 lying within the main collector region 18. After the opening 28 is formed, a heavy doping of n type impurity, such as phosphorus, is deposited on the area of the base region 24 that is exposed through the opening 28. The substrate is heated at 930°C for 2 hours and 20 minutes during the phosphorus deposition and diffusion, to form an emitter region 30 beneath the opening 28. Thereafter the emitter region 30 is annealed by heating the substrate at 800°C for 42 minutes. The depth of the emitter region 30 is 8,000 angstroms. During the emitter annealing step, a thin oxide layer forms over the emitter region 30.

The next series of steps comprising metalization is shown in Figure 7 wherein multiple openings are formed in the oxide layer 12a over the main collector region 18 where four Schottky diodes are to be formed, and single openings are provided over the emitter region 30, over the base region 24 and over the channel stop region 26 adjoining the thin collector region 18a. The contact metallization is preferably multilayered, there being a first platinel silicide layer making direct contact to the silicon, followed by a barrier layer of titanium tungsten, and then a layer of aluminum. The metallization layers are patterned to form four contacts 32 for the Schottky diodes on the main collector region 18, an emitter contact 34 on the emitter region 30, a base contact 36 on the base region 24, and a collector contact 38 for the pnp clamping transistor, which will be further described.

The platinel silicide layer which is formed directly on the semiconductor surface may comprise a ternary alloy of 50% silicon, 44% nickel and 6% platinum. The platinel silicide alloy may be produced by sputter depositing a composition of 88% nickel and 12% platinum on the silicon and heating the silicon to form the ternary alloy. A process for producing the platinel silicide contacts is disclosed in U.S. Patent 3,855,612 to Rosvold. This process produces a platinum-nickel-silicon ternary alloy on the semiconductor surface. In the n type collector region 18 it forms a Schottky barrier contact for the four Schottky diodes D1 through D4 of Figure 1. In the other regions it forms ohmic contacts to the emitter region 30, the base region 24, and the pnp collector at the channel stop region 26.

The titanium tungsten barrier layer between the platinel silicide and the aluminum layer prevents the aluminum from diffusing into the platinel silicide and silicon. The aluminum is preferred for its high conductivity and low melting point.

Other processing steps which are well known in the art include the application of a low melting point phospho-silicate glass layer over the aluminum contacting layer, a top aluminum layer for supply conductors and interconnects, and a passivating layer of phospho-silicate glass.

The npn inverter transistor T1 of Figure 1 is constituted in Figure 7 by the emitter region 30, base region 24, and collector region 18. The pnp clamping transistor T2 has a vertical component constituted by the region 24 as the emitter, the thin region 18a as the base, and the substrate 10 as the collector. The pnp clamping transistor T2 also has a lateral component including the region 24 as emitter, the thin region 18a as the base, and the channel stop region 26 as the collector, with the lateral spacing at the surface between regions 24 and 26 determining the base thickness of the lateral clamping component.

It will be seen that the thickness of the thin region 18a which forms the base of the pnp clamping transistor is not limited by the thickness of an epitaxial layer of the prior art. The thickness of the pnp clamping transistor is determined by the difference in thickness between the two diffused regins 18a and 24. Since the depth of both these regions 18a and 24 can be controlled by both the temperature and the length of time of diffusion, a wider range of control over the base thickness is afforded. More importantly, the small thickness achievable can be very thin, as small as a few thousand angstroms.

An important beneficial result that flows from a small base thickness for the pnp clamping transistor is that its current gain $\beta_f$ can be increased substantially. Experimentally results have shown that the current gain $\beta_f$ can be increased by a factor of 3 over a corresponding epitaxial structure.

In Figure 7, the electrical connections to the various elements of the triple diffused structure are shown schematically with reference characters corresponding to those of Figure 1. In practice, these connections, for the most part, would be made during the second metallization. The current source I of Figure 1 is shown in Figure 7 as a resistor coupled to a positive supply. The current source resistor may be present in an adjacent resistor tub 19 and may be formed during the same diffusion steps in the process that forms the regions 24 and 26, often referred to as the base diffusion of the npn transistor.

The triple diffused structure produced according to the invention has several important advantages. The increased current gain $\beta_f$ for the pnp clamping transistor offers a speed improvement for switching the npn inverter or switching transistor. Because the triple diffusion process is simpler than the epitaxial process, it should result in lower cost and higher yield.

## Claims

1. Integrated circuit comprising a semiconductor body having a surface, a substrate region of a first conductivity type adjoining said surface, a first surface region of a second conductivity type being present in said substrate region and having a higher doping concentration than an adjoining part of said substrate region, said first surface region extending a first depth below said surface, a second surface region of the first conductivity type being present in said first surface region and having a higher doping concentration than an adjoining part of said first surface region, said second surface region having a second depth below said surface which is smaller than said first depth, a third surface region of the second conductivity type being present in said second surface region and having a higher doping concentration than an adjoining part of said second surface region, said third surface region having a third depth below said surface which is smaller than said second depth, characterized in that

said first surface region has a major portion having said first depth and a laterally-adjoining minor portion extending to a fourth depth below said surface which is smaller than said first depth and larger than said second depth, said minor portion having a lower doping concentration than said major portion, said second surface region being located partly in said major portion and partly in said minor portion of said first surface region, said third surface region being located entirely within a portion of said second surface region which extends in the major portion of the first surface region.

2. Integrated circuit as claimed in Claim 1, characterized in that a circumscribing surface region of the first conductivity type is present in said substrate region and having a higher doping concentration than an adjoining part of said substrate region, said circumscribing surface region surrounding and extending partly into said first surface region at said surface.

3. Integrated circuit as claimed in Claim 1 or 2, characterized in that at said surface ohmic contacts are present respectively on said third surface region, on said second surface region and on said circumscribing surface region, and at said surface one or more rectifying contacts are present which each form a Schottky diode with an adjoining part of said major portion of said first surface region.

4. Integrated circuit as claimed in Claim 1, 2 or 3, characterized in that said substrate region has p-type conductivity.

5. Integrated circuit as claimed in one or more of the preceding Claims, characterized in that said first depth is about 7 $\mu$m and said fourth depth is about 2 $\mu$m.

6. Integrated circuit as claimed in any of the preceding Claims, characterized in that said fourth depth is about 2 $\mu$m and said second depth is about 1 $\mu$m.

7. A method of fabricating a semiconductive structure, comprising:

a) providing a semiconductor body having a surface and a substrate region of a first conductivity type adjoining said surface;

b) diffusing a first region of a second conductivity type into said substrate region extending to said surface and into said substrate region a predetermined first depth below said surface;

c) diffusing a second surface region of the first conductivity type extending into said first region a second depth below said surface that is less than said first depth;

d) diffusing a third surface region of the second conductivity type into said second surface region and extending a third depth below said surface that is less than the second depth;

e) depositing ohmic contacts on said second surface region, said third surface region, and said substrate region, characterized in that the method further comprises:

f) diffusing a further region of the second conductivity type into said substrate region contiguous with and forming an extension of said first region, said further region having a lighter doping concentration than the greater part of said first region, said further region extending to said surface and into said substrate region a fourth depth that is substantially less than said first depth, said first region and said further region forming a major portion and a minor portion, respectively, of a contiguous first surface region,

g) depositing a plurality of contacts spaced apart on the surface of said major portion of said first surface region and each forming a Schottky barrier therewith; and in that said second surface region is diffused to extend partly into said major portion and partly into said minor portion, said second depth being less than said fourth depth, said third surface region being diffused entirely within a portion of the second surface region which is located in said major portion of said first surface region.

8. A method as claimed in Claim 7, characterized in that a circumscribing region of the first conductivity type is diffused into said substrate region and having a higher doping concentration than an adjoining part of said substrate region, said circumscribing region at the surface of said substrate region merging with the perimeter of said major portion and with the perimeter of said minor portion, and wherein the ohmic contact to said substrate region as set forth in step e) is deposited on said circumscribing region.

9. A method as claimed in Claim 8, characterized in that said circumscribing region is produced during the same diffusion step that produces said second surface region.

10. A method as claimed in Claim 7, 8 or 9, characterized in that said major portion is diffused to a first depth of about 7 micrometers.

11. A method as claimed in Claim 7, 8, 9 or 10, characterized in that said minor portion is diffused to a fourth depth of about 2 micrometers.

12. A method as claimed in Claim 7, 8, 9, 10 or 11, characterized in that said second surface region is diffused to a second depth of about 1 micrometer.

13. A method as claimed in Claim 12, characterized in that said third surface region is diffused to a third depth of about 0.8 micrometer.

**Patentansprüche**

1. Integrierte Schaltung mit einem Halbleiterkörper mit einer Oberfläche, einem an die Oberfläche grenzenden Substratgebiet eines ersten Leitungstyps, wobei ein erstes Oberflächengebiet eines zweiten Leitungstyps und mit einer höheren Dotierungskonzentration als ein angrenzender Teil des genannten Substratgebietes in dem genannten Substratgebiet vorhanden ist, wobei das genannte ersten Substratgebiet sich über eine erste Tiefe unterhalb der genannten Oberfläche erstreckt,

wobei in dem ersten Oberflächengebiet ein zweites Oberflächengebiet vom ersten Leitungstyp und mit einer höheren Dotierungskonzentration als ein angrenzender Teil des ersten Oberflächengebietes vorhanden ist, wobei dieses zweite Oberflächengebiet sich über eine zweite Tiefe unterhalb der genannten Oberfläche erstreckt, wobei diese zweite Tiefe kleiner ist als die erste Tiefe,

wobei in dem zweiten Oberflächengebiet ein drittes Oberflächengebiet vom zweiten Leitungstyp und mit einer höheren Dotierungskonzentration als ein angrenzender Teil des zweiten Oberflächengebietes vorhanden ist, wobei dieses dritte Oberflächengebiet sich über eine dritte Tiefe unterhalb der genannten Oberfläche erstreckt, wobei diese Tiefe kleiner ist als die zweite Tiefe, dadurch gekennzeichnet, dass

das erste Oberflächengebiet einen grösseren Teil auf der genannten ersten Tiefe hat und einen lateral angrenzenden kleineren Teil, der sich bis zu einer vierten Tiefe unterhalb der genannten Oberfläche erstreckt, wobei diese Tiefe kleiner ist als die genannte erste Tiefe und grösser als die genannte zweite Tiefe, wobei dieser kleinere Teil eine niedrigere Dotierungskonzentration aufweist als der genannte grössere Teil, wobei das zweite Oberflächengebiet teilweise in dem grösseren Teil und teilweise in dem kleineren Teil des genannten ersten Oberflächengebietes liegt, wobei das dritte Oberflächengebiet völlig innerhalb eines Teils des genannten zweiten Oberflächengebietes liegt, der sich in dem grösseren Teil des genannten ersten Oberflächengebietes erstreckt.

2. Integrierte Schaltung nach Anspruch 1, dadurch gekennzeichnet, dass umgrenzendes Oberflächengebiet vom ersten Leitungstyp in dem Substratgebiet vorhanden ist und eine höhere Dotierungskonzentration aufweist als ein angrenzeder Teil des genannten Substratgebietes, wobei diese umgrenzende Oberflächengebiet sich teilweise in das erste Oberflächengebiet auf der genannten Oberfläche erstreckt und dieses Gebiet umgibt.

3. Integrierte Schaltung nach Anspruch 1 oder 2, dadurch gekennzeichnet, dass auf der genannten Oberfläche auf dem genannten dritten Oberflächengebiet, auf dem genannten zweiten Oberflächengebiet und auf dem genannten umgrenzenden Oberflächengebiet ohmsche Kontakte vorgesehen sind und dass auf der genannten Oberfläche ein oder mehrere Gleichrichtkontakte vorhanden sind, die mit einem angrenzenden Teil des genannten grösseren Teils des genannten ersten Oberflächengebietes je eine Schottky-Diode bilden.

4. Integriete Schaltung nach Anspruch 1, 2 oder 3, dadurch gekennzeichnet, dass das genannte Substrategebiet p-leitend ist.

5. Integrierte Schaltung nach einem der vorstehenden Ansprüche, dadurch gekennzeichnet, dass die genannte erste Tiefe etwa 7 µm beträgt und die genannte vierte Tiefe etwa 2 µm beträgt.

6. Integrierte Schaltung nach einem der vorstehenden Ansprüche, dadurch gekennzeichnet, dass die genannte vierte Tiefe etwa 2 µm beträgt und die genannte zweite Tiefe etwa 1 µm beträgt.

7. Verfahren zum Herstellen einer Halbleiterstruktur, bei dem die folgenden Verfahrensschritte durchgeführt werden:

a) das Schaffen eines Halbleiterkörpers mit einer Oberfläche und einem an die genannte Oberfläche grenzenden Substratgebiet eines ersten Leitungstyps;

b) das in das genannte Substratgebiet Eindiffundieren eines ersten Gebietes eines zweiten Leitungstyps, das sich bis an die genannte Oberfläche und über eine vorbestimmte Tiefe unterhalb der genannten Oberfläche in das genannte Substratgebiet erstreckt;

c) das in das genannte erste Substratgebiet Eindiffundieren eines zweiten Oberflächengebietes vom ersten Leitungstyp, das sich über eine zweite Tiefe, die kleiner ist als die genannte erste Tiefe, unterhalb der genannten Oberfläche in das genannte erste Gebiet erstreckt;

d) das in das genannte zweite Oberflächengebiet Eindiffundieren eines dritten Oberflächengebietes vom zweiten Leitungstyp, das sich über eine dritte Tiefe, die kleiner ist als die zweite Tiefe, unterhalb der genannten Oberfläche erstreckt;

e) das Niederschlagen ohmscher Kontakte auf dem zweiten Oberflächengebiet, auf dem dritten Oberflächengebiet sowie auf dem Substratgebiet, dadurch gekennzeichnet, dass das Verfahren weiterhin die folgenden Verfahrensschritte aufweist;

f) das in das Substratgebiet Eindiffundieren eines weiteren Gebietes vom zweiten Leitungstyp, wobei diese Substratgebiet an das erste Gebiet grenzt und eine Fortsetzung desselben ist, wobei dieses weiter Gebiet eine niedrigere Dotierungskonzentration aufweist als der grössere Teil des ersten Gebietes und wobei das weitere Gebiet sich bis an die Oberfläche und über eine vierte Tiefe, die wesentlich geringer ist als die erste Tiefe, in das Substratgebiet erstreckt und wobei das erste Gebiet und das weitere Gebiet einen Hauptteil bzw. einen Nebenteil eines angrenzenden ersten Oberflächengebietes bilden,

g) das Niederschlagen einer Anzahl beabstandeter Kontakte auf der Oberfläche des Hauptteils des ersten Oberflächenteils, wobei diese Kontakte mit der Oberfläche eine Schottky-Sperrschicht bilden und dass das genannte zweite Oberflächengebiet eindiffundiert ist, damit es sich teilweise in den Hauptteil und teilweise in den Nebenteil erstreckt, wobei die zweite Tiefe geringer ist als die vierte Tiefe, wobei das dritte Oberflächengebeit völlig innerhalb eines in dem Hauptteil des ersten Oberflächengebietes liegenden Teils des zweiten Oberflächengebietes eindiffundiert ist.

8. Verfahren nach Anspruch 7, dadurch gekennzeichnet, dass ein umgrenzendes Gebiet vom ersten Leitungstyp in das genannte Substratgebiet eindiffundiert ist und eine höhere Dotierungskonzentration aufweist aus der angrenzenden Teil des genannten Substratgebietes, wobei das umgrenzende Gebiet an der Oberfläche des Substratgebietes mit der Peripherie des genannten Hauptteils und mit der Peripherie des genannten Nebenteils verschmolzen ist und dass der ohmsche Kontakt mit dem beim Verfahrensschritt e) genannten Substratgebiet auf dem umgrenzenden Gebiet niedergeschlagen ist.

9. Verfahren nach Anspruch 8, dadurch gekennzehnet, dass das umschreibende Gebiet während desselben Diffusionsschrittes erzeugt wird, in dem das zweite Oberflächengebiet erzeugt wird.

10. Verfahren nach Anspruch 7, 8 oder 9, dadurch gekennzeichnet, dass der genannte Hauptteil über eine erste Tiefe von etwa 7 µm eindiffundiert wird.

11. Verfahren nach Anspruch 7, 8, 9 oder 10, dadurch gekennzeichnet, dass der genannte Nebenteil über eine Tiefe von etwa 2 µm eindiffundiert wird.

12. Verfahren nach Anspruch 7, 8, 9, 10 oder 11, dadurch gekennzeichnet, dass das genannte zweite Oberflächengebiet über eine zweite Tiefe von etwa 1 µm eindiffundiert wird.

13. Verfahren nach Anspruch 12, dadurch gekennzeichnet, dass das genannte dritte Oberflächengebiet über eine dritte Tiefe von etwa 0,8 µm eindiffundiert wird.

**Revendications**

1. Circuit intégré muni d'un corps semiconducteur comportant une surface, une région de substrat d'un premier type de conductivité confinant à ladite surface, une première région superficielle d'un second type de conductivité étant présente dans ladite région de substrate et présentant une concentration de dopage plus élevée que celle d'une partie contiguë de ladite région de substrat, ladite première région superficielle s'étendant à une première profondeur au-dessous de ladite surface,

une deuxième région superficielle de surface du premier type de conductivité étant présente dans ladite première région superficielle et présentant une concentration de dopage plus élevée que celle d'une partie contiguë de ladite première région superficielle, ladite deuxième région superficielle ayant une deuxième profondeur au-dessous de ladite surface qui est inférieure à ladite première profondeur,

une troisième région superficielle du second type de conductivité étant présente dans ladite deuxième région superficielle et présentant une concentration de dopage plus élevée que celle d'une partie contiguë de ladite deuxième région superficielle, ladite troisième région superficielle ayant une troisième profondeur au-dessous de ladite surface qui est inférieure à ladite deuxième profondeur,

caractérisée en ce que ladite première région superficielle est munie d'une partie principale présentant ladite première profondeur et d'une partie secondaire latéralement attenante s'étendant à une quatrième profondeur au-dessous de ladite surface qui est inférieure à ladite première profondeur et plus grande que ladite deuxième profondeur, ladite partie secondaire présentant une concentration de dopage inférieure à celle de ladite partie principale, ladite deuxième région superficielle étant située partiellement dans ladite partie principale et partiellement dans ladite partie secondaire de ladite première région superficielle, ladite troisième région superficielle étant située entièrement dans une partie de ladite deuxième région superficielle qui s'étend dans la partie principale de la première région superficielle.

2. Circuit intégré selon la revendication 1, caractérisé en ce qu'une région superficielle de circonscription du premier type de conductivité est présente dans ladite région de substrat et présente une concentration de dopage plus élevée que celle d'une partie contiguë de ladite région de substrat, ladite région superficielle de circonscription entourant et s'étendant partiellement dans ladite première région superficielle à ladite surface.

3. Circuit intégré selon la revendication 1 ou 2, caractérisé en ce qu'à ladite surface, des contacts ohmiques sont présents respectivement sur ladite troisième région superficielle, sur ladite deuxième région superficielle et sur ladite région superficielle de circonscription et qu'à ladite surface, un ou plusieurs contacts redresseurs sont présents et forment chacun une diode Schottky avec une partie contiguë de ladite partie principale de ladite première région superficielle.

4. Circuit intégré selon la revendication 1, 2 ou 3, caractérisé en ce que ladite région de substrat présente une conductivité de type p.

5. Circuit intégré selon l'une ou plusieurs des revendications précédentes, caractérisé en ce que ladite première profondeur est d'environ 7 μm et ladite quatrième profondeur est d'environ 2 μm.

6. Circuit intégré selon l'une des revendications précédentes, caractérisé en ce que ladite quatrième profondeur est d'environ 2 μm et ladite deuxième profondeur est d'environ 1 μm.

7. Procédé pour la fabrication d'une structure semiconductrice comportant

a) la réalisation d'un corps semiconducteur présentant une surface et une région de substrat d'un premier type de conductivité confinant à ladite surface;

b) la diffusion d'une première région d'un second type de conductivité dans ladite région de substrat s'étendant vers ladite surface et dans ladite région de substrat à une première profondeur préalablement déterminée au-dessous de ladite surface.

c) la diffusion d'une deuxième région superficielle du premier type de conductivité s'étendant dans ladite première région à une deuxième profondeur au-dessous de ladite surface qui est inférieure à ladite première profondeur;

d) la diffusion d'une troisième région superficielle du deuxième type de conductivité dans ladite deuxième région superficielle s'étendant à une troisième profondeur au-dessous de ladite surface qui est inférieure à la deuxième profondeur;

e) le dépôt de contacts ohmiques sur ladite deuxième région superficielle, ladite troisième région superficielle et ladite région de substrat, caractérisé en ce que le procédé comprend en outre;

f) la diffusion d'une autre région du deuxième type de conductivité dans ladite région de substrate contiguë à et formant un prolongement de ladite première région, ladite autre région présentant une concentration de dopage inférieure à celle de la partie principale de ladite première région, ladite autre région s'étendant vers ladite surface et dans ladite région de substrat à une quatrième profondeur qui est notablement inférieure à ladite première profondeur, ladite première région et ladite autre région formant une partie principale et une partie secondaire respectivement d'une première région supercielle contiguë;

g) le dépôt d'une pluralité de contacts espacés sur la surface de ladite partie principale de ladite première région superficielle formant chacun une barrière Schottky avec cette dernière et en ce que ladite deuxième région superficielle est diffusée de façon à s'étendre partiellement dans ladite partie principale et partiellement dans ladite partie secondaire, ladite deuxième profondeur étant inférieure à ladite quatrième profondeur, ladite troisième région superficielle étant diffusée entièrement dans une partie de la deuxième région superficielle située dans ladite partie principale de ladite première région superficielle.

8. Procédé selon la revendication 7, caractérisé en ce qu'une région de circonscription du premier type de conductivité est diffusée dans ladite région de substrat et présente une concentration de dopage plus élevée que celle d'une partie contiguë de ladite région de substrat, ladite région de circonscription à la surface de ladite région de substrat constituant un ensemble avec le perimètre de ladite grande partie avec le perimètre de ladite partie secondaire et dans lequel le contact ohmique avec ladite région de substrat comme mentionnée ci-dessus dans l'étant e) est déposé sur ladite région de circonscription.

9. Procédé selon la revendication 8, caractérisé en ce que ladite région de circonscription est réalisée pendant la même étape de diffusion qui réalise ladite deuxième région superficielle.

10. Procédé selon la revendication 7, 8 ou 9, caractérisé en ce que ladite partie principale est diffusée jusqu'à une première profondeur d'environ 7 micromètres.

11. Procédé selon la revendication 7, 8, 9 ou 10, caractérisé en ce que ladite partie secondaire est diffusée jusqu'à une quatrième profondeur d'environ 2 micromètres.

12. Procédé selon la revendication 7, 8, 9, 10 ou 11, caractérisé en ce que ladite deuxième région superficielle est diffusée jusqu'à une deuxième profondeur d'environ 1 micromètre.

13. Procédé selon la revendication 12, caractérisé en ce que ladite troisième région superficielle est diffusée jusqu'à une troisième profondeur d'environ 0,8 micromètre.

Fig.7

Fig.1

## Fig.2

## Fig.3

12  16                    14

N

18        18        18

18

10

P—

## Fig.4

12a                14a  16a

N—

N

18a  18

18        18        18

10

P—

## Fig.5

22    12a              20        22

26                    24        26

N

18a

18                    18        18

10

P—

## Fig.6

10    12a          28  30

26

N

18a  26

26              18    24    18

P—

2